(19) Europäisches Patentamt / European Patent Office / Office européen des brevets

(11) **EP 4 394 394 A1**

(12) **EUROPEAN PATENT APPLICATION**

(43) Date of publication:
**03.07.2024 Bulletin 2024/27**

(21) Application number: **23383362.3**

(22) Date of filing: **22.12.2023**

(51) International Patent Classification (IPC):
**G01R 15/24** $^{(2006.01)}$    **G01R 19/00** $^{(2006.01)}$

(52) Cooperative Patent Classification (CPC):
**G01R 15/242; G01R 15/241;** G01R 19/0084

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.12.2022 ES 202231115**

(71) Applicant: **AIRBUS OPERATIONS, S.L.U.**
**28906 Getafe (Madrid) (ES)**

(72) Inventors:
- **VICENTE OLIVEROS, David**
  **28906 Getafe (Madrid) (ES)**
- **ANDRES GONZALEZ, Carlos**
  **28906 Getafe (Madrid) (ES)**
- **SALES MAICAS, Salvador**
  **46022 Valencia (ES)**
- **GARCIA MIGUEL, Hector**
  **46022 Valencia (ES)**

(74) Representative: **Herrero & Asociados, S.L.**
**Edificio Aqua - Agustín de Foxá, 4-10**
**28036 Madrid (ES)**

(54) **ELECTRIC VOLTAGE MEASURING DEVICE USING A MICROELECTROMECHANICAL SYSTEM WITH GRAPHENE**

(57)    Electrical Voltage Measurement Device (1000), comprising at least one microelectromechanical device (120) comprising a semitransparent material element (150) with a variable refractive index n according to an electrical voltage applied to said element, a first electrode (A) connectable to an anode (+) of an electrical voltage source (110) and electrically connected to a first point of the semitransparent material element (150), a second electrode (B) connectable to a cathode (-) of said electrical voltage source (110) and electrically connected to a second point of the semitransparent material element (150), wherein the semitransparent material element (150) is configured to receive an electrical voltage from the electrical voltage source (110) through the first electrode (A) and/or the second electrode (B), causing a variation $\Delta n(V)$ in the refractive index $n$ proportionally to said electrical voltage; and an optical device (140).

FIG. 1

EP 4 394 394 A1

**Description**

**Object of the invention**

The present invention relates to devices for measuring electric voltage values using microelectromechanical devices and optical processors.

**Background of the invention**

Microelectromechanical Systems (MEMS) are micrometric devices that can contain moving parts, as well as processing or sensing units. MEMS can be used for a wide variety of applications ranging from ink deposition in printers to inertial measurement (accelerometers and gyroscopes). Their micrometric scale allows for easy installation and implementation in combination with optical interferometry.

Optical interferometry is a technique based on the analysis of interference patterns of emitted and reflected light to determine quantities such as distance or roughness.

Graphene is a laminar material formed by carbon atoms and is obtained from graphite. Among its characteristics are hardness, flexibility, and thermal and electrical conductivity. Currently, it has numerous applications in technology, particularly in photonics. Since graphene is composed of a single-atom-thick layer of carbon atoms (monolayer thickness), it is a material with high optical transparency in the spectrum range corresponding to visible, near-infrared, and ultraviolet wavelengths. For example, monolayer graphene transmits around 97.7% in the visible range and, therefore, is highly transparent.

Unfortunately, conventional methods for measuring electrical voltage use active electronic components that require electrical power, and therefore, pose a fire hazard through the generation of sparks, overheating, and short circuits. Therefore, for measuring electrical voltage in fuel cells, being able to measure electrical voltage by micromechanical and optical methods exclusively would greatly increase safety.

Unfortunately, conventional techniques for measuring electrical voltage at multiple points often require a large number of electrical lines, since each sensor has to be part of an isolated circuit. When the number of measurement points increases, for example, to measure the individual output of each element in a battery comprising multiple elements, composed of multiple cells, the disorder of the electrical lines significantly increases, adding complexity to the wiring system and its installation, as well as its weight, cost, and maintenance.

Therefore, there is a demand for obtaining small-scale strain gauges that provide measurements with a high level of accuracy, that are safe, easily scalable, that have a low manufacturing cost, and that use non-electrical measurement methods.

The present invention meets this demand.

**Description of the Invention**

The present invention relates to a device for measuring voltage values proportional to a variation $\Delta n(V)$ in the refractive index $n$ of a semitransparent material element, for example, a layer of graphene as part of a microelectromechanical device. The variation $\Delta n(V)$ in the refractive index $n$ of the semitransparent material element is detectable by optical interferometry. The device allows scalability and can comprise one or more electromechanical or microelectromechanical devices with graphene.

The electrical voltage values are obtained by analyzing interferometry patterns of optical signals affected by the variation $\Delta n(V)$ in the refractive index $n$ of the semitransparent material element, which changes according to the electrical voltage being measured. Through an optical device using optical interferometry, electrical voltage values, or a variation in electrical voltage, are determined.

Thus, in a first aspect, the invention pertains to a device for measuring electrical voltage values, comprising at least one microelectromechanical device that includes a semitransparent material element, for example, a layer of graphene, with a refractive index $n$,, and a first electrode electrically connected to the graphene layer. The first electrode can be connected to an anode of an electrical voltage source. The device also includes a second electrode electrically connected to the graphene layer and connectable to a cathode of the electrical voltage source. $Al_2O_3$ films are established between each electrode and the graphene layer, maintaining electrical isolation between the two electrodes as $Al_2O_3$ has high resistivity, serving as an insulator.

In one example, the first electrode is coated by a first layer of electrical insulator, and the second electrode is coated by a second layer of electrical insulator. In a particularization, the first and second layers of electrical insulator comprise aluminum oxide.

The semitransparent material element is configured to receive electrical voltage from the voltage source, causing a variation $\Delta n(V)$ in the refractive index $n$ of the semitransparent material element proportional to the electrical voltage.

The device also includes an optical device configured to transmit an optical signal through the semitransparent material element and detect, through the optical device, an amplitude or phase modulation of the modified optical signal due to the interaction with the semitransparent material element. Said amplitude or phase modulation is proportional to the variation $\Delta n(V)$ in the refractive index $n$.

Through the optical device, interference patterns can be obtained based on the amplitude or phase modulation of the modified optical signal, and the optical device can calculate the value of the electrical voltage from the voltage source to be measured or a variation in electrical voltage. This value or variation in electrical voltage can be determined based on the interference patterns detected in the optical device.

In one example, the microelectromechanical device is a MEMS device configured to receive electrical voltage from the electrical voltage source, causing a variation $n$ in the refractive index $\Delta n(V)$ of a graphene layer proportional to the electrical voltage. The optical device consists of an optical fiber that transmits light from an optical source, receives it, and returns it to an optical sensor, for example, a photodetector.

The optical device can detect amplitude and/or phase modulation of the modified optical signal, which is proportional to the variation $n$ in the refractive index $\Delta n(V)$ of the graphene layer. Through the optical device, interference patterns are obtained based on the amplitude and/or phase modulation of the optical signal, and the optical device calculates the value of the electrical voltage (or a variation in electrical voltage) from the voltage source to be measured. This electrical voltage is determined based on the interference patterns detected in the optical processor

In a first alternative, the device includes a reflective (or partially reflective) plate, for example, a metallic plate, and the semitransparent material element comprises a graphene layer. The optical device includes a terminal of an optical fiber that forms a partially reflective element and is configured to receive the optical signal modified by the graphene layer, a laser, and an optical sensor. The optical device is configured to project the laser's optical signal through the optical fiber toward the graphene layer. The optical signal undergoes double reflection: one reflection of the optical signal modified by the graphene layer on the metallic plate and another reflection at the fiber-air interface. The coexistence of these two optical signals, the one reflected at the fiber-air interface and the one reflected on the metallic plate, causes optical interference. This interference pattern depends on the refractive index of the graphene layer $n$, which in turn depends on the electrical voltage applied to the graphene layer. The variation $\Delta n(V)$ in the refractive index $n$ of the graphene layer generates changes in amplitude and phase of the reflection of the optical signal, producing interference patterns dependent on the refractive index $n$ of the graphene layer.

The optical signal coming from the optical device, functioning as an interferometer, can be transmitted remotely from the electrical voltage measurement device via the optical fiber. Thus, the electrical processing of the interferometer's optical signals can also be carried out remotely, where there are no safety requirements present in the storage area of voltage sources, which could be, for example, hydrogen fuel cells (it is of interest that there are no electrically powered devices in the location of fuel cells that could cause explosions in the event of possible short circuits).

Advantageously, optical interferometry carried out by the optical device does not require electrical power at the measurement point, thereby minimizing the risk of fire through spark generation, overheating, and short circuits. This is crucial in applications involving highly flammable substances, such as hydrogen (hydrogen fuel cells), or in any other environment where there is a risk of explosion or fire.

In a second alternative, the optical device comprises an optical fiber, a laser, and an optical sensor. The optical fiber includes two branches: a first branch and a second branch, parallel to the first branch. In this embodiment, the semitransparent graphene plate is positioned between the first branch of the optical fiber, which is divided into two sections, and the second branch of the optical fiber is interrupted by the atmosphere (air). The optical device is configured to transmit the optical signal through both the first and second branches using the laser. In the first branch, the optical signal is affected by a phase and/or amplitude variation that is proportional to the variation $\Delta n(V)$ in the refractive index n,of the graphene layer. With the two optical signals, one passing through the graphene layer and the other through the air, interference patterns are obtained. These interference patterns arise from the variation in phase and amplitude of the optical signal through the first branch and the phase of the optical signal through the second branch (reference phase).

In another example, the second branch is interrupted by a second semitransparent material element with geometry equivalent to the semitransparent material element (graphene). In another example, the second branch is continuous. The first and second branches can be under identical environmental conditions: humidity, temperature, and/or atmosphere type.

Interrupting the second branch, placing in the interrupted portion of the second branch a semitransparent material element identical to the semitransparent material element interposed in the first branch-without applying electrical voltage to the semitransparent material element interposed in the second branch-and/or ensuring that the first branch and the second branch are under the same environmental conditions allows for increased sensitivity of a device according to the invention.

In the second alternative, the optical device can analyze a modulation of phase and/or amplitude of the optical signal transmitted through an optical fiber compared to a reference phase, where the phase modulation of the optical signal is directly related to the variation in $\Delta n(V)$ the refractive index $n$ of the graphene layer.

Another aspect of the invention relates to a system comprising the device according to the first aspect of the invention and at least one electrical voltage source. The electrical voltage source can be a fuel cell or a battery.

## Description of the Drawings

To complement the description being made and to help a better understanding of the features of the device for measuring electrical voltage values according to the present invention, schematic representations are provided, which, with an illustrative and nonlimiting nature, depict the following:

Figure 1 shows a first example of a device for measuring electrical voltage values according to the present invention.

Figure 2 shows a second example of a device for measuring electrical voltage values according to the present invention.

## Detailed Embodiment of the invention

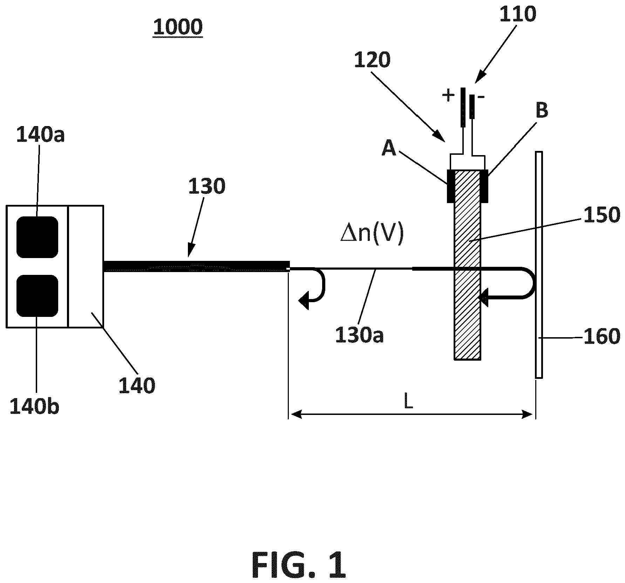

Figure 1 shows a first example of a device (1000) for measuring electrical voltage values according to the present invention. The device (1000) comprises a microelectromechanical device (120) (for example, a MEMS) comprising a first electrode (A) connected to an anode (+)of an electrical voltage source (110), a second electrode (B) connected to a cathode (-)of said electrical voltage source (110), and a semitransparent material element (150), particularly, a graphene layer with a refractive index $n$. The graphene layer is electrically connected to the first electrode (A) and the second electrode (B). Between the first electrode (A), the second electrode (B), and the graphene layer, an insulating layer, for example, aluminum oxide, is interposed to prevent the flow of current between the first electrode (A) and the second electrode (B).

The microelectromechanical device (120) is configured to receive electrical voltage from the electrical voltage source (110), causing a variation $\Delta n(V)$ in the refractive index $n$ of the graphene layer proportional to the electrical voltage.

The voltage values are proportional to a variation in $\Delta n(V)$ the refractive index $n$. This variation $\Delta n(V)$ can be detectable and measured by an optical device (140) that functions as an interferometry system, creating an interferometric cavity (130a) using an optical fiber (130).

The optical device (140) may include different elements depending on the configuration of the device (1000) for measuring electrical voltage values. In this particular embodiment, the optical device (140) comprises the optical fiber (130), a laser (140a), and an optical sensor (140b).

The device (1000), moreover, includes a reflective plate (160), for example, a metallic plate established at a distance L from one end of the optical fiber (130), as can be seen in Figure 1.

The optical device (140) is configured to project, through the laser (140a), the optical signal through the optical fiber (130) and towards the graphene layer, where the optical signal passes through the graphene layer obtaining a modified optical signal and undergoes reflection against the metallic plate.

The optical device (140) is configured to detect, through the optical fiber (130) and using the optical sensor (140b), the optical signal reflected at the fiber-air interface and the optical signal modified by the graphene layer and reflected on the metallic plate. The variation $\Delta n(V)$ in the refractive index $n$ of the graphene layer generates a variation in amplitude of the reflected modified optical signal.

The optical device (140) is configured to obtain interference patterns based on the optical signal reflected at the fiber-air interface and the optical signal modified by the graphene layer and reflected on the metallic plate.

Finally, the optical device (140) is configured to calculate the value (or a variation) of the electrical voltage (110) based on the interference patterns. In addition, the device allows for the detection of a variation in electrical voltage.

Thus, the optical device (140), functioning as an interferometer, generates an interferometric cavity (130a) and detects through the sensor (140b) the optical signal and the reflection of the modified optical signal with the metallic plate, forming interference patterns. The interference patterns based on the optical signal and its reflection may vary depending on the modulation in amplitude of the reflected optical signal caused by the variation $n$ in the refractive index $\Delta n(V)$ of the graphene layer.

From the variation in interference patterns, the value of the electrical voltage applied to the electrodes (A, B) electrically connected to the graphene layer and provided by the electrical voltage source (110), which can be, for example, a fuel cell, can be derived. Therefore, modifications in the amplitude of the reflected signal, causing notable changes in interference patterns, can be detected through the optical device (140).

As shown in Figure 1, the anode (+) and cathode (-) terminals of the electrical voltage source (110) are connected to the first electrode (A) and a second electrode (B) in the microelectromechanical device (120), respectively. When the electrical voltage source (110) applies a voltage to the microelectromechanical device (120), electrostatic forces generated by this voltage act on the graphene layer, causing a variation $\Delta n(V)$ in the refractive index $n$ of the graphene layer that is proportional to the potential difference or voltage applied by the electrical voltage source (110) to the microelectromechanical device (120). An insulating layer of aluminum oxide is established between the electrodes (A) and (B) and the graphene layer to prevent conduction between the electrodes of the microelectromechanical device (120).

As shown in Figure 1, the optical fiber (130) is aligned to project a light beam representing the optical signal through the graphene layer. The optical signal is modified when passing through the graphene layer and collides with the metallic plate, causing a reflection of the optical signal that enters the optical fiber (130) through the optical fiber terminal. The optical fiber terminal forms a (partially) reflective element in such a way that it reflects a part of the optical signal emitted by the laser (140a) and transmits it back to the optical sensor (140b), forming a reference signal to generate optical interference by comparing this reference signal with the modified optical signal.

Figure 1 also shows the interferometric cavity (130a). The optical signal, the reflected optical signal, and the reflection at the end of the fiber (fiber-air interface) constitute the interferometric cavity (130a), and its response is guided through the optical fiber (130) to the optical device (140), as shown in Figure 1. In particular, the response of the interferometric cavity (130a) is read in the optical device (140), as interference patterns vary based on the modulation in amplitude of the reflected optical signal due to the variation $\Delta n(V)$ in the refractive index $n$.

The optical device (140), functioning as a laser interrogator or interferometer, can accurately measure the modulation in amplitude of the reflected optical signal, such that:

$$FSR = c/(2 * n * L) = c/[2 * (nair * Lair + n * Lgraphene)].$$

$$FSR' = c/(2 * n * L) = c/[2 * (nair * Lair + (n + \Delta n\,(V)) * Lgraphene)]$$

$$\Delta FSR(V) = FSR - FSR'$$

wherein *FSR* is the free spectral range observed in the interference pattern obtained by the optical device (140) taking into account the refractive index ($n$) of the graphene layer, and where *FSR'* is the free spectral range observed in the interference pattern obtained by the optical device (140) considering the refractive index ($n$) of the graphene layer with a variation in the refractive index $\Delta n(V)$, and where *nair* is the refractive index of air, and c is the speed of light.

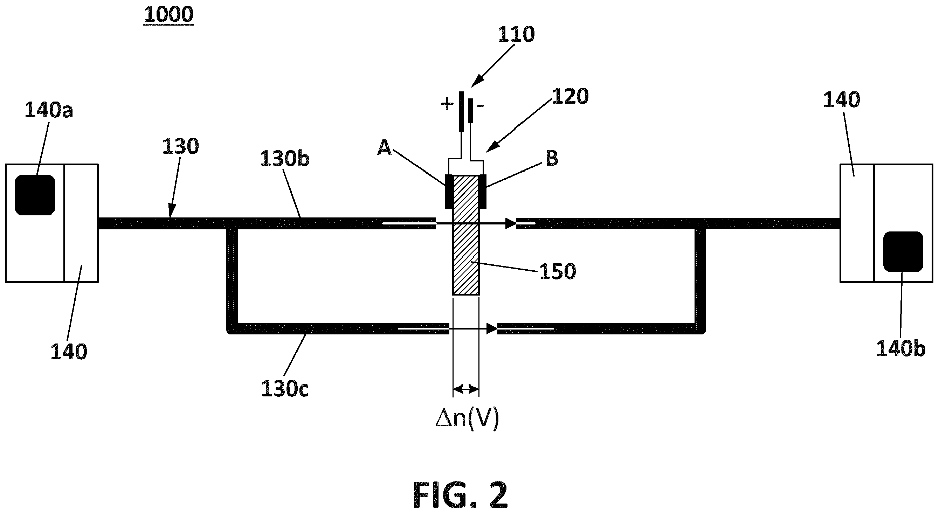

Figure 2 shows another embodiment of the device (1000) for measuring electrical values according to the present invention. In this embodiment, the device (1000) functions as a Mach-Zehnder Modulator (MZM). The Mach-Zehnder Modulator (MZM) is an interferometric structure made of a material with strong electro-optical effects (such as LiNbO3, GaAs, InP).

The microelectromechanical device (120) of the device (1000) is configured to receive an electrical voltage from the electrical voltage source (110), causing a variation $\Delta n(V)$ in the refractive index $n$ of the semitransparent material element (150) (e.g., a graphene layer) proportional to said electrical voltage, which is electrically connected to the first electrode (A) and the second electrode (B). Between the electrodes (A) and (B) and the graphene layer is a thin layer of aluminum oxide, insulating, to prevent conduction between the electrodes of the MEMS.

The optical device (140) comprises a laser (140a) configured to transmit an optical signal, with a specific phase, through the optical fiber (130). The optical fiber (130) comprises a first branch (130b) and a second branch (130c) parallel to the first branch (130b). Thus, the light signal is split through the first branch (130b) and the second branch (130c).

The optical device (140) comprises an optical sensor (140b) configured to detect the optical signals at the opposite end of the first branch (130b) and the second branch (130c). As shown in Figure 2, the semitransparent material element (150) is interposed between a first part of the first branch (130b) and a second part of the first branch (130b), intersecting the path of the optical signal through the first branch (130b).

The optical device (140) is configured to detect, through the optical sensor (140b), a variation in the phase of the modified optical signal through the first branch (130b). Said phase variation is proportional to the variation in the $\Delta n(V)$ refractive index $n$. When voltage is applied to the graphene layer, the phase of the optical signal passing through the graphene layer in the first branch (130b) varies with respect to the reference phase of the optical signal through the second branch (130c), as the reference phase is not disturbed by the graphene layer.

The optical device (140) is configured to obtain interference patterns based on the phase variation of the modified optical signal through the first branch (130b) compared to the reference phase of the optical signal through the second branch (130c).

In an example, the first branch (130b) and the second branch (130c) experience identical environmental conditions. Environmental conditions may include one or more of the following conditions: humidity, temperature, and/or type of atmosphere.

The application of an electric field by the electrical voltage source (110) alters the refractive index $n$ of the graphene layer, changing the lengths of the optical paths, resulting in a phase modulation of the light signal passing through the graphene layer via the first branch (130b). Therefore, when a voltage is applied to the graphene layer, the phase of the light passing through it varies with respect to the reference phase of the undisturbed signal passing through the other line. The combination of the optical signals and the variation in their phases can be related to intensity modulation. This interference pattern can be measured in the other line, such that:

$$FSR = c/(n * L) = c/[nair * Lair + n * Lgraphene]$$

$$FSR' = c/(n * L) = c/[(nair * Lair + (n + \Delta n(V)) * Lgraphene)]$$

$$\Delta FSR(V) = FSR - FSR'$$

wherein $FSR$ is the observed free spectral range in the interference pattern obtained by the optical device (140) considering the refractive index $n$ of the graphene layer, and $FSR'$ is the observed free spectral range in the interference pattern obtained by the optical device (140) considering the refractive index $n$ of the graphene layer with a variation in the refractive index $\Delta n(V)$, and wherein nair is the refractive index of air, and $c$ is the speed of light.

**Claims**

1. Electrical Voltage Measurement Device (1000), comprising:

   at least one microelectromechanical device (120) comprising:

   - a semitransparent material element (150) with a variable $n$ refractive index according to an electrical voltage applied to said element;
   - a first electrode (A) connectable to an anode (+) of an electrical voltage source (110) and electrically connected to a first point of the semitransparent material element (150);
   - a second electrode (B) connectable to a cathode (-) of said electrical voltage source (110) and electrically connected to a second point of the semitransparent material element (150),

   wherein the semitransparent material element (150) is configured to receive an electrical voltage from the electrical voltage source (110) through the first electrode (A) and/or the second electrode (B), causing a variation $\Delta n(V)$ in its refractive index $n$ proportional to said electrical voltage; and
   an optical device (140) configured to:

   - transmit an optical signal through the semitransparent material element (150);
   - capture at least one optical signal modified by the interaction of the optical signal with the semitransparent material element (150);
   - detect an amplitude or phase modulation of the modified optical signal that is proportional to the variation $\Delta n(V)$ in the refractive index $n$;
   - obtain interference patterns based on at least said amplitude or phase modulation of the optical signal; and
   - calculate a value of the electrical voltage of the electrical voltage source (110) based on the interference patterns.

2. Electrical Voltage Measurement Device (1000) according to Claim 1, further comprising a reflective plate (160), a laser (140a), and an optical sensor (140b), wherein the optical device (140) is configured to:

   - project through the laser (140a) the optical signal towards the semitransparent material element (150) causing the modification of the optical signal;
   - capture a reflection of the modified optical signal on the reflective plate (160);
   - detect, through the optical sensor (140b), the variation $\Delta n(V)$ in the refractive index $n,$ wherein the variation $\Delta n(V)$ generates a variation in amplitude of the reflection of the modified optical signal;
   - obtain interference patterns based on the variation in amplitude of the reflection of the modified optical signal.

3.  Device (1000) according to Claim 2, wherein the optical device (140) comprises an optical fiber (130) configured to transmit the optical signal from the laser (140a), and
    wherein a terminal of the optical fiber (130) forms a partially reflective element.

4.  Device (1000) according to Claims 2 or 3, wherein the reflective plate (160) is a metallic plate.

5.  Device (1000) according to Claim 1, wherein the optical device (140) comprises a laser (140a), an optical sensor (140b), and an optical fiber (130) comprising a first branch (130b) and a second branch (130c) parallel to the first branch (130b), wherein the semitransparent material element (150) is interposed between a first part of the first branch (130b) and a second part of the first branch (130b), wherein the optical device (140) is configured to:

    - transmit, through the laser (140a), the optical signal through the first branch (130b) and the semitransparent material element (150);
    - transmit, through the laser (140a), the optical signal through the second branch (130c);
    - detect, through the optical sensor (140b), a modified optical signal through the first branch (130b), wherein the phase and/or amplitude variation of the modified optical signal is proportional to the variation $\Delta n(V)$ in the refractive index $n$ of the semitransparent material element (150);
    - detect, through the optical sensor (140b), a reference optical signal through the second branch (130c);
    - obtain interference patterns based on the phase and/or amplitude variation of the modified optical signal with respect to the reference optical signal.

6.  Device (1000) according to Claim 5, wherein the second branch (130c) is interrupted by:

    - the atmosphere; and/or
    - a second element of semitransparent material with a geometry equivalent to the semitransparent material element (150) interposed between the first part of the first branch (130b) and the second part of the first branch (130b).

7.  Device (1000) according to Claim 5, wherein the second branch (130c) is continuous.

8.  Device (1000) according to Claims 5 to 7, wherein the first branch (130b) and the second branch (130c) are under identical environmental conditions.

9.  Device (1000) according to the preceding claim, wherein the environmental conditions comprise one or more of the following conditions:

    - hygrometry,
    - temperature, and/or
    - type of atmosphere.

10. Device (1000) according to the preceding claims, wherein the microelectromechanical device (120) is a MEMS.

11. Device (1000) according to the preceding claims, wherein the semitransparent material element (150) comprises a graphene layer.

12. Device (1000) according to the preceding claims,
    wherein the first electrode (A) is coated by a first layer of electrical insulator, and the second electrode (A) is coated by a second layer of electrical insulator.

13. Device (1000) according to the preceding claim, wherein the first layer of electrical insulator and the second layer of electrical insulator comprise aluminum oxide.

14. System comprising:

    - the device (1000) according to the preceding claims; and
    - at least one electrical voltage source (110).

15. System according to the preceding claim, wherein the electrical voltage source (110) is a fuel cell or a battery.

**1000**

110

120

140a

130

A

B

Δn(V)

140

150

130a

140b

L

160

**FIG. 1**

**FIG. 2**

EP 4 394 394 A1

Europäisches
Patentamt

European
Patent Office

Office européen
des brevets

# EUROPEAN SEARCH REPORT

Application Number

EP 23 38 3362

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 864 220 A (AOSHIMA SHINICHIRO [JP] ET AL) 5 September 1989 (1989-09-05) | 1-4,10, 12-15 | INV. G01R15/24 |
| Y | * the whole document * | 5-9 | |
| A | | 11 | ADD. G01R19/00 |
| X | CN 112 924 741 A (UNIV CHONGQING) 8 June 2021 (2021-06-08) | 1,10, 12-15 | |
| Y | * the whole document * | 11 | |
| A | | 2-9 | |
| X | US 2003/042884 A1 (KINGSLEY STUART A [US] ET AL) 6 March 2003 (2003-03-06) | 1,10, 12-15 | |
| A | * paragraph [0025] – paragraph [0064]; figures 1, 9 * | 2-9 | |
| Y | WO 2019/225445 A1 (UNIV KEIO [JP]) 28 November 2019 (2019-11-28) | 11 | |
| A | * paragraph [0034]; figures 1-6B * | 1-10, 12-15 | |
| A | US 2009/290165 A1 (BOHNERT KLAUS [CH] ET AL) 26 November 2009 (2009-11-26) * the whole document * | 1-15 | TECHNICAL FIELDS SEARCHED (IPC) G01R B82Y |
| Y | PASSARO ET AL: "Electromagnetic field photonic sensors", PROGRESS IN QUANTUM ELECTRONICS, PERGAMON PRESS, OXFORD, GB, vol. 30, no. 2-3, 16 November 2006 (2006-11-16), pages 45-73, XP005728820, ISSN: 0079-6727, DOI: 10.1016/J.PQUANTELEC.2006.08.001 | 5-9 | |
| A | * the whole document * | 1-4, 10-15 | |

–/--

The present search report has been drawn up for all claims

| Place of search | Date of completion of the search | Examiner |
|---|---|---|
| Munich | 2 May 2024 | Ako, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

Europäisches
Patentamt
European
Patent Office
Office européen
des brevets

# EUROPEAN SEARCH REPORT

Application Number

EP 23 38 3362

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ORTEGA B ET AL: "Electrooptic poled fibre switch/modulator", FIBRES AND OPTICAL PASSIVE COMPONENTS, 2005. PROCEEDINGS OF 2005 IEEE/ LEOS WORKSHOP ON MONDELLO, ITALY JUNE 22-24, 2005, PISCATAWAY, NJ, USA,IEEE, 22 June 2005 (2005-06-22), pages 416-421, XP010813806, DOI: 10.1109/WFOPC.2005.1462165 ISBN: 978-0-7803-8949-6 | 5-7 | |
| A | * the whole document * | 1-4,8-15 | |

-----

TECHNICAL FIELDS
SEARCHED     (IPC)

The present search report has been drawn up for all claims

| Place of search | Date of completion of the search | Examiner |
|---|---|---|
| Munich | 2 May 2024 | Ako, Thomas |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

                              

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 23 38 3362

This annex lists the patent family members relating to the patent documents cited in the above-mentioned European search report.
The members are as contained in the European Patent Office EDP file on
The European Patent Office is in no way liable for these particulars which are merely given for the purpose of information.

02-05-2024

| Patent document cited in search report | | Publication date | Patent family member(s) | | Publication date |
|---|---|---|---|---|---|
| US 4864220 | A | 05-09-1989 | DE | 3884489 T2 | 27-01-1994 |
| | | | EP | 0299427 A2 | 18-01-1989 |
| | | | JP | H0695114 B2 | 24-11-1994 |
| | | | JP | S6418070 A | 20-01-1989 |
| | | | US | 4864220 A | 05-09-1989 |
| CN 112924741 | A | 08-06-2021 | NONE | | |
| US 2003042884 | A1 | 06-03-2003 | US | 6479979 B1 | 12-11-2002 |
| | | | US | 2003042884 A1 | 06-03-2003 |
| WO 2019225445 | A1 | 28-11-2019 | JP | 7454852 B2 | 25-03-2024 |
| | | | JP | WO2019225445 A1 | 10-06-2021 |
| | | | WO | 2019225445 A1 | 28-11-2019 |
| US 2009290165 | A1 | 26-11-2009 | CA | 2671587 A1 | 03-07-2008 |
| | | | CN | 101568842 A | 28-10-2009 |
| | | | EP | 2095136 A1 | 02-09-2009 |
| | | | US | 2009290165 A1 | 26-11-2009 |
| | | | WO | 2008077256 A1 | 03-07-2008 |

EPO FORM P0459

For more details about this annex : see Official Journal of the European Patent Office, No. 12/82